# FASCICULE DE BREVET EUROPEEN

(11) **EP 3 116 005 B1**
(45) Date de publication et mention de la délivrance du brevet: **13.06.2018**
(21) Numéro de dépôt: 16178102.6
(22) Date de dépôt: 06.07.2016
(51) Int. Cl.: H01H 3/16, H02B 11/133, H01R 13/703, H01H 1/42

(54) **MODULE DEBROCHABLE PORTE PAR UNE EMBASE POUR LA MESURE DE COURANT SUR UN RESEAU ELECTRIQUE**
ABNEHMBARES MODUL VON EINEM SOCKEL FÜR DIE STROMMESSUNG IN EINEM STROMNETZ
REMOVABLE MODULE SUPPORTED BY A BASE FOR MEASURING CURRENT OVER AN ELECTRICAL NETWORK

(30) Priorité: 08.07.2015 FR 1556484
(43) Date de publication de la demande: 11.01.2017
(73) Titulaire: Schneider Electric Industries SAS, 92500 Rueil-Malmaison (FR)
(72) Inventeur: MARMONIER, Jean, 38050 Grenoble Cedex 9 (FR); VAN DER MEE, Marnix, 38050 Grenoble Cedex 9 (FR)
(74) Mandataire: Brevalex

(56) Documents cités:
- EP-A1- 1 469 571
- US-A- 5 989 043
- US-A1- 2006 034 025
- US-A1- 2007 218 741

## Description

### DOMAINE TECHNIQUE

L'invention concerne un système comprenant une embase et un module débrochable de cette embase permettant de mesurer une intensité de courant d'une ligne pour assurer la protection d'un réseau électrique moyenne ou haute tension.

### ÉTAT DE LA TECHNIQUE ANTÉRIEURE

Un tel système mesure continuellement l'intensité du courant électrique d'une ligne faisant partie d'un réseau électrique. Ces mesures permettent de détecter d'éventuels dysfonctionnements, pour commander le cas échéant l'ouverture ou la fermeture d'interrupteurs ou de disjoncteurs afin de sécuriser tout ou partie du réseau.

Un tel système comporte un module débrochable porté par une embase fixe correspondante qui est installée à demeure en étant par exemple fixée à un rail support.

L'embase est raccordée à des capteurs équipant une ou plusieurs lignes électriques de type moyenne ou haute tension sur lesquelles les mesures d'intensité électrique sont effectuées. Chaque capteur comporte un noyau ferromagnétique torique entourant le conducteur sur lequel le courant est mesuré, avec un bobinage formé sur au moins une portion du noyau torique, et dont les bornes sont raccordées à l'embase du système.

Depuis cette embase, la paire de câbles de chaque capteur est électriquement reliée à un transformateur de mesure monté dans le module pour assurer la mesure effective d'intensité.

En pratique, il est indispensable que les bobinages des capteurs de mesure équipant les lignes soient court-circuités avant de débrocher le module de l'embase pour le retirer par exemple pour le remplacer.

Concrètement, le fait de laisser de tels bobinages ouverts provoque leur endommagement pouvant conduire à une explosion, ainsi que l'apparition d'une forte surtension au niveau de la filerie qui est notamment susceptible d'électrocuter un opérateur se trouvant à proximité du circuit ouvert.

Dans des domaines autres que celui de lignes moyenne et haute tension, il existe des modules s'engageant dans des embases, mais ils sont inadaptables au domaine de l'invention, ce qui est par exemple le cas du dispositif décrit dans le document de brevet US2007/218741.

Le but de l'invention est d'apporter une solution assurant que les bobinages soient nécessairement mis en court-circuit avant de pouvoir débrocher le module.

### EXPOSÉ DE L'INVENTION

L'invention a pour objet un système comprenant une embase et un module débrochable s'emboîtant dans cette embase, l'embase étant destinée à être électriquement reliée à au moins un capteur d'intensité équipant une ligne électrique pour mesurer une intensité de courant transporté par cette ligne, chaque capteur comprenant un bobinage, le module comprenant pour chaque capteur un transformateur de mesure électriquement connecté via l'embase au bobinage du capteur correspondant, pour mesurer l'intensité du courant circulant dans la ligne, l'embase comportant pour chaque capteur un interrupteur pour court-circuiter chaque bobinage de capteur en cas de retrait du module, l'embase comportant un mécanisme d'actionnement des interrupteurs pour les ouvrir ou les fermer, un levier de manoeuvre équipant le module en étant apte à verrouiller le module dans l'embase, ce levier de manoeuvre s'accouplant avec le mécanisme d'actionnement des interrupteurs lorsque le module est emboîté dans l'embase, ce levier de manoeuvre étant mobile entre une première position de verrouillage mécanique du module dans l'embase et d'ouverture de chaque interrupteur, et une deuxième position de fermeture des interrupteurs et de déverrouillage du module de l'embase.

Cet agencement assure que les bobinages des capteurs sont court-circuités lorsque le module est effectivement retiré, ce qui évite l'apparition de surtensions aux bornes de ces bobinages, et des risques d'électrocution y afférents.

L'invention concerne également un système ainsi défini, dans lequel :
- l'embase comporte un arbre rotatif d'actionnement de chaque interrupteur qui est mobile entre une position d'ouverture et une position de fermeture de chaque interrupteur, et au moins un coulisseau d'entraînement de l'arbre lié en mouvement à cet arbre par une liaison de type pignon-crémaillère ;
- le levier de manoeuvre du module est lié en mouvement à chaque coulisseau de l'embase lorsque ce module est emboîté dans l'embase, pour placer l'arbre en position d'ouverture lorsque le levier occupe sa première position, et pour placer cet arbre en position de fermeture lorsque le levier occupe sa deuxième position.

L'invention concerne également un système ainsi défini, dans lequel le levier de manoeuvre est monté basculant sur le module qui le porte, dans lequel chaque coulisseau comporte une encoche d'accouplement recevant une extrémité correspondante du levier lorsque le module est emboîté dans l'embase, pour qu'un déplacement du levier provoque un déplacement correspondant des coulisseaux et de l'arbre rotatif.

L'invention concerne également un système ainsi défini, comportant des moyens pour déclencher l'ouverture des interrupteurs lorsque le levier occupe une position intermédiaire entre sa première position et sa seconde position, et des moyens pour activer des mesure du courant circulant dans la ligne lorsque le levier a atteint sa première position.

L'invention concerne également un système ainsi défini, comportant des moyens pour temporiser le déplacement du levier depuis sa deuxième position jusqu'à sa première position.

L'invention concerne également un système ainsi défini, dans lequel les moyens pour temporiser le déplacement du levier comprennent un pion rigidement solidaire du levier et coulissant dans une gorge en étant en appui sur un bord de cette gorge, cette gorge étant portée par une armature mobile rappelée par des ressorts pour maintenir son bord en appui sur le pion, le bord comprenant entre ses extrémités un ergot pour bloquer le pion dans sa course, l'armature comprenant un bouton poussoir pouvant être enfoncé par un opérateur pour enfoncer l'armature mobile à l'encontre des ressorts de manière à effacer l'ergot pour permettre au pion de continuer sa course le long du bord.

L'invention concerne également un système ainsi défini, dans lequel l'arbre et les coulisseaux sont sensiblement inaccessibles à un opérateur lorsque le module est retiré, pour interdire une manoeuvre des interrupteurs en l'absence du module.

### BRÈVE DESCRIPTION DES DESSINS

- la figure 1 est une vue d'ensemble du dispositif selon l'invention lorsque le module est enfiché dans l'embase ;
- la figure 2 est un schéma électrique du dispositif selon l'invention connecté à des moyens de mesure du courant transporté par une ligne triphasée haute ou moyenne tension lorsque le module est enfiché dans l'embase ;
- la figure 3 est une vue d'ensemble du dispositif selon l'invention lorsque le module est retiré de l'embase ;
- la figure 4 est un schéma électrique du dispositif selon l'invention connecté à des moyens de mesure du courant transporté par une ligne triphasée haute ou moyenne tension lorsque le module est retiré de l'embase ;
- la figure 5 est une vue d'ensemble en éclaté des composants de l'embase du dispositif selon l'invention ;
- la figure 6 est une vue d'ensemble des composants de l'embase du dispositif selon l'invention ;
- la figure 7 est une vue de détail montrant les éléments constitutifs d'un interrupteur de court-circuitage du dispositif selon l'invention ;
- la figure 8 est une vue en perspective d'une levier de manoeuvre du dispositif selon l'invention représenté seul ;
- la figure 9 est une vue en coupe latérale d'un dispositif selon l'invention lorsque le module est en place dans l'embase et que les capteurs sont normalement connectés ;
- la figure 10 est une vue en coupe latérale d'un dispositif selon l'invention lorsque le module est en place dans l'embase alors que les capteurs sont court-circuités ;
- la figure 11 est une vue en coupe latérale d'un dispositif selon l'invention lorsque le module est débroché de son embase et que les capteurs sont court-circuités ;
- la figure 12 est une vue en perspective d'une armature représentée seule qui est destinée à entourer une poignée du levier de manoeuvre du module pour indexer son mouvement ;
- la figure 13 est une vue en perspective du levier du module avec l'armature d'indexation entourant sa poignée ;
- la figure 14 est une vue latérale du levier de manoeuvre avec l'armature d'indexation lorsque le levier est en position haute ;
- la figure 15 est une vue latérale du levier de manoeuvre avec l'armature d'indexation lorsque ce levier est bloqué par l'armature au cours de son mouvement d'abaissement ;
- la figure 16 est une vue latérale du levier de manoeuvre avec l'armature d'indexation une fois que celle-ci a été enfoncée par l'opérateur pour permettre l'abaissement complet du levier;
- la figure 17 est une vue latérale du levier de manoeuvre avec l'armature d'indexation une fois que ce levier a été complètement abaissé ;
- la figure 18 est une vue latérale du levier de manoeuvre avec l'armature d'indexation enfoncée dès le début de l'abaissement du levier;
- la figure 19 est une vue latérale du levier de manoeuvre avec l'armature d'indexation enfoncée qui bloque ce levier sensiblement à mi-course en empêchant son abaissement complet.

### EXPOSÉ DÉTAILLÉ DE MODES DE RÉALISATION PARTICULIERS

L'idée à la base de l'invention est d'assurer que les interrupteurs de court-circuitage qui sont portés par l'embase, soient manoeuvrés par un mécanisme porté par le module débrochable qui est accouplé à un mécanisme porté par l'embase.

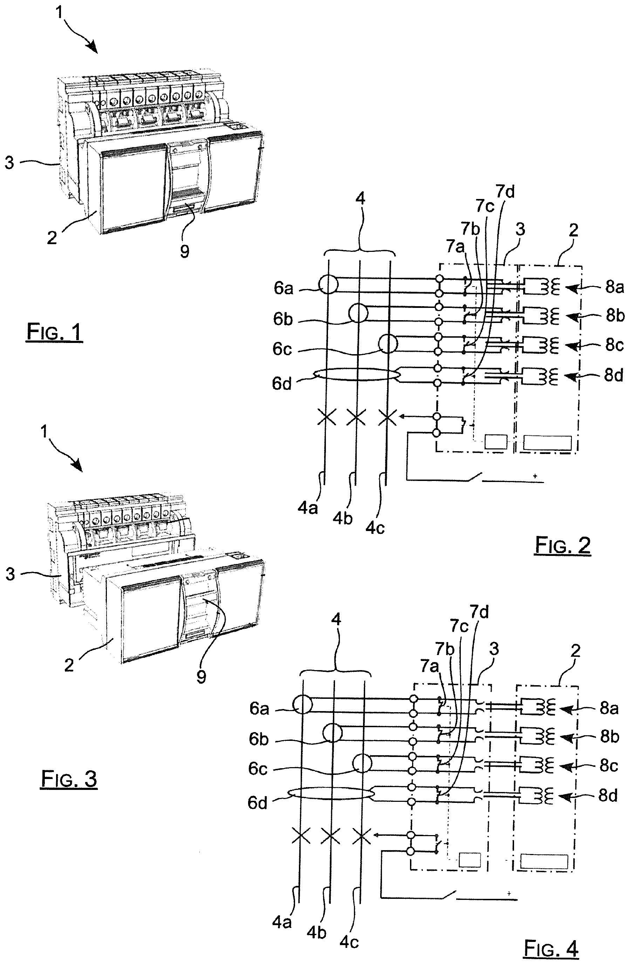

Le dispositif selon l'invention qui apparaît sur la figure 1 en y étant repéré par 1 comporte un module 2 débrochable qui est emboîté de manière amovible dans une embase fixe 3 qui est portée par un support fixe non représenté.

Ce dispositif 1 qui est situé à distance d'une ligne de transport de courant 4 de type moyenne tension, est raccordé à quatre capteurs équipant cette ligne 4.

Plus particulièrement, cette ligne 4 qui est triphasée comporte trois conducteurs 4a, 4b, 4c, entourés chacun par un capteur de courant correspondant 6a, 6b et 6c, ces conducteurs étant de plus entourés conjointement par un capteur additionnel 6d qui les entoure tous les trois pour mesurer le courant global dans cette ligne.

Le capteur 6a est raccordé à l'embase 3 par une paire de câbles, cette embase 3 étant équipée d'un interrupteur correspondant 7a pour court-circuiter cette paire de câble et par là même le bobinage du capteur 6a lorsque cet interrupteur est électriquement fermé.

Cette embase 3 comporte en outre des moyens de connexion électrique des deux câbles du capteur 6a au module enfichable 2 qui est quant à lui équipé de moyens de mesure du courant traversant le bobinage de ce capteur 6a.

L'ensemble comprenant le capteur 6a avec ses câbles de raccordement, l'interrupteur 7a, et les moyens de mesure constitue ainsi un système de mesure du courant véhiculé par le conducteur 4a de la ligne moyenne tension 4.

Trois autres systèmes de mesure du même type sont prévus, comportant chacun notamment un capteur et un interrupteur, pour mesurer le courant passant dans le second conducteur 4b, dans le troisième conducteur 4c, et dans l'ensemble des trois conducteurs 4a-4c de cette ligne 4. Ces trois autres systèmes comportent les capteurs 6b-6d et les interrupteurs de court-circuitage 7a-7d analogues.

En fonctionnement, normal comme dans la figure 1, le module 2 est enfiché dans l'embase 3, et les interrupteurs 7a-7d de cette embase sont ouverts, pour que le module puisse réaliser les mesures du courant traversant les capteurs 6a-6d.

Dans cette configuration, et comme visible sur les figures 2 et 4, le bobinage de chaque capteur est électriquement relié à un transformateur de mesure correspondant 8a-8d qui est situé dans le module 2 pour réaliser les mesures électriques. Ainsi, lorsque le module est retiré, comme dans la figure 4, les transformateurs de mesure 8a-8d sont nécessairement déconnectés des capteurs correspondants.

Lors du retrait du module 2, par exemple pour le changer ou pour y effectuer des modifications, une manette frontale 9 de ce module est d'abord manoeuvrée par l'opérateur vers le haut pour le libérer de l'embase 3. Autrement dit, cette manette 9 autorise le déboîtement du module, uniquement lorsqu'elle est en position haute.

Le fait de relever cette manette 9, en plus de libérer le module 2 pour autoriser son déboitement, agit sur un mécanisme interne de l'embase 3 qui ferme les interrupteurs de court-circuitage 7a-7d. Le retrait du module 2 est ainsi possible seulement lorsque les interrupteurs de court-circuitage ont été fermés, ce qui correspond à la situation des figures 3 et 4.

La manette 9, avec le levier qui la porte, est ainsi mobile entre une première position qui est une position basse correspondant à celle de la figure 1, et une seconde position qui est une position haute correspondant à celle de la figure 3.

La première position est une position d'ouverture des interrupteurs de court-circuitage 7a-7d et de verrouillage mécanique du module dans l'embase. La seconde position est au contraire une position de fermeture des interrupteurs et de déverrouillage du module pour permettre son retrait de l'embase.

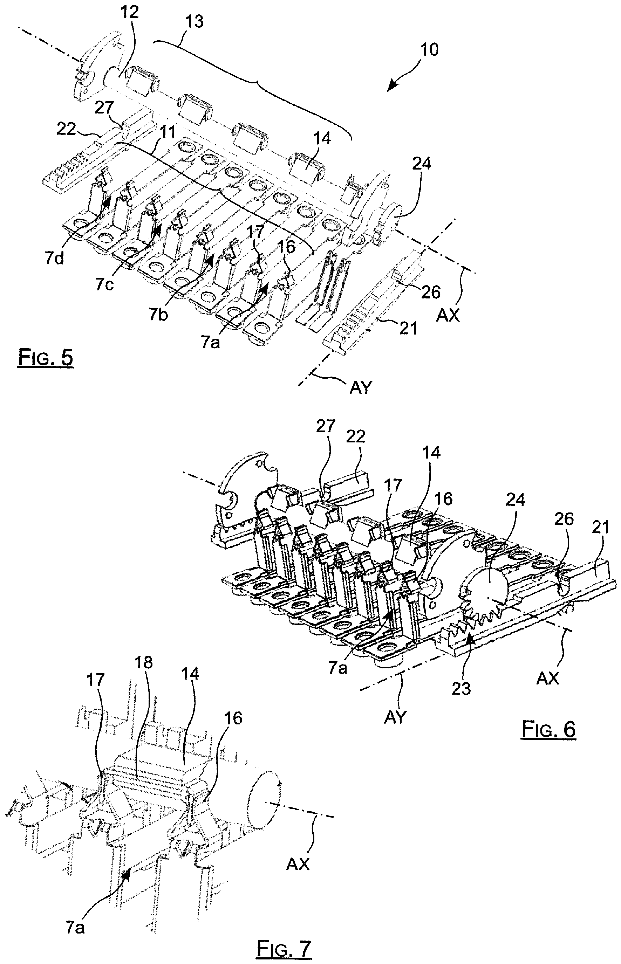

Le mécanisme interne de l'embase qui apparaît en éclaté dans la figure 5 en y étant repéré par 10, comporte une partie fixe par rapport à l'embase qui porte une série 11 de quatre paires de contacteurs fixes, et un axe rotatif 12 tournant autour d'un axe AX, qui porte une série 13 de quatre contacteurs mobiles. Chaque paire de contacteurs fixes coopère avec l'un des contacts mobiles pour constituer un interrupteur de court-circuitage.

Plus particulièrement, et comme visible sur la figure 5, l'interrupteur de court-circuitage 7a comporte un contacteur mobile 14 porté par l'axe rotatif 12, et deux contacteurs fixes 16 et 17 qui sont reliés chacun à l'un des câbles de connexion du capteur 6a.

Chaque contacteur fixe 16, 17 a une forme générale de pince comprenant deux touches en appui élastique l'une contre l'autre en étant orientée pour pouvoir recevoir entre ces touches un élément métallique plan d'orientation perpendiculaire à l'axe AX.

Le contacteur mobile 14 comporte quant à lui un insert 18 formé d'une plaque métallique rectangulaire dont les extrémités sont repliées à angle droit pour constituer des ailes de contact électrique. Cette plaque ou insert 18 présente ainsi, lorsque vue de profil, une forme correspondant à la lettre U, ses ailes étant espacées l'une de l'autre d'une distance correspondant à la distance séparant les pinces des contacts fixes 16 et 17 le long de l'axe AX.

L'axe 12 est mobile entre une position d'ouverture correspondant aux figures 5 et 6, et une position de fermeture correspondant à la figure 7. Dans la position d'ouverture le contact mobile 14 est espacé des contacts fixes 16 et 17 pour ouvrir l'interrupteur 7a, et dans la position de fermeture, ce contact mobile 14 a ses ailes engagées respectivement dans les contacts fixes 16 et 17 pour fermer l'interrupteur 7a.

De la même manière que l'interrupteur de court-circuitage 7a est formé d'un contact mobile 14 porté par l'axe 12 associé à deux contacts fixes 16, 17, chacun des autres interrupteurs 7b-7d est aussi constitué de deux contacteurs fixes et d'un contacteur mobile de même type que ceux de l'interrupteur 7a.

Tous ces contacts fixes de la série 11 sont alignés parallèlement à l'axe AX pour être à faible distance de l'axe 12 en le longeant, chaque paire de contacts fixes étant en vis-à-vis d'un contact mobile correspondant de la série de contacts 14. Les contacts mobiles 14 sont eux aussi alignés le long de l'axe 12 qui les porte, en étant orientés de sorte que les ailes de leur contacts sont perpendiculaires à l'axe AX.

Ainsi, lorsque l'axe ou arbre 12 occupe sa position d'ouverture, tous les interrupteurs 7a-7d sont électriquement ouverts, et lorsqu'il occupe sa position de fermeture, tous ces interrupteurs sont au contraire électriquement fermés pour court-circuiter les bobinages des capteurs 6a-6d.

L'axe de manoeuvre 12 des interrupteurs de court-circuitage 7a-7d est déplacé de sa position d'ouverture à sa position de fermeture et inversement, par l'intermédiaire de deux coulisseaux 21, 22 auxquels il est relié par deux liaisons pignon-crémaillère situées à ses extrémités.

Le coulisseau 21 est mobile en translation selon un axe AY perpendiculaire à l'axe AX, et il est situé dans la région de l'extrémité de l'arbre 12 la plus proche du contacteur mobile du premier interrupteur 7a, en étant espacé de cet arbre 12 selon une direction normale aux axes AX et AY.

Ce coulisseau 21 comprend à l'aplomb de l'axe AX une dentelure 23 dans laquelle est engrené un pignon 24 rigidement solidaire de l'extrémité de l'axe 12, l'arbre 12 étant ainsi relié au coulisseau 21 par une liaison de type pignon-crémaillère.

L'autre coulisseau, à savoir le coulisseau 22 est orienté parallèlement au coulisseau 21 en étant situé au niveau de l'extrémité opposée de l'arbre 12 et en étant lié à cet arbre par une autre liaison pignon-crémaillère.

Les deux coulisseaux assurent ainsi complémentairement la même fonction de déplacement de l'arbre 12, et ils sont au nombre de deux pour équilibrer les efforts qui interviennent lorsqu'ils sont actionnés.

Comme visible sur la figure 6, le coulisseau 21 comporte une encoche 26 et le coulisseau 22 comporte une autre encoche 27 analogue, chaque encoche 26 et 27 étant située à distance de la portion dentée du coulisseau dans lequel elle est formée, pour assurer un accouplement avec un levier de manoeuvre basculant.

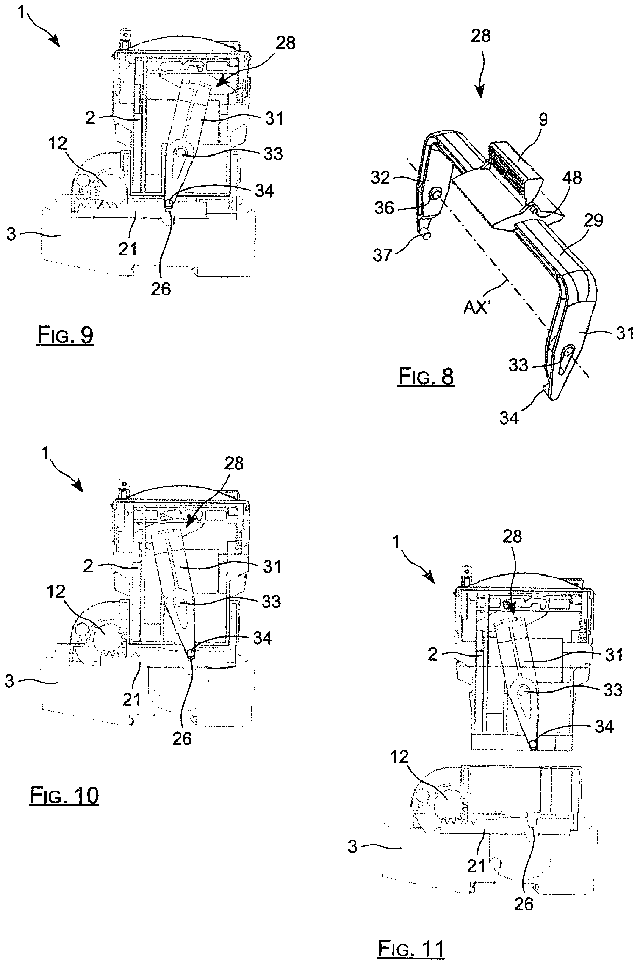

Ce levier de manoeuvre basculant 28 qui est représenté seul dans la figure 8, comporte une portion centrale 29 portant la manette 9 en son milieu, et deux branches latérales 31 et 32 parallèles l'une à l'autre et orientées perpendiculairement à la portion centrale 29. La branche latérale 31 comporte un trou 33 dans sa portion centrale et un ergot 34 à son extrémité, et de manière analogue, la branche 32 comporte aussi un trou 36 dans sa région centrale et un ergot 37 à son extrémité.

Ce levier 28 est monté sur le module 2 qui le porte de manière à être basculant autour des trous 33 et 36, c'est-à-dire autour d'un axe AX' parallèle à l'axe AX et situé à mi-longueur des branches 31 et 32. Par ailleurs, les ergots 34 et 37 sont engagés dans les encoches 26 et 27 des coulisseaux lorsque le module 2 est emboîté dans l'embase 3.

Lorsqu'il est monté dans le module 2 qui le porte, comme illustré sur les figures 9 à 11, le levier 28 est ainsi apte à pivoter autour d'un axe AX' parallèle à l'axe AX, pour basculer entre une première position basse et une seconde position haute, cet axe AX' de basculement correspondant aux trous 33 et 36 réalisés dans ses branches 31 et 32.

Par ailleurs, lorsque le module 2 est emboîté dans l'embase 3, les ergots 34 et 37 situés en extrémité de chacune des branches 31 et 32 du levier 28 sont engagés dans les encoches correspondantes 26 et 27 des coulisseaux 21 et 22. Le levier 28 est ainsi accouplé avec le mécanisme 13 de commande des interrupteurs 7a-7d dès que le module est enfiché dans l'embase.

Le basculement du levier 28 de sa première position, correspondant au verrouillage et représentée sur la figure 9, à sa seconde position correspondant au déverrouillage et illustrée sur les figures 10 et 11 provoque un déplacement des coulisseaux 21 et 22. Ceux-ci font alors tourner l'arbre 12 de la position d'ouverture vers la position de fermeture des interrupteurs 7a-7d.

En pratique, c'est l'opérateur qui, en remontant la poignée 9 qui est située en façade du module débrochable 2, provoque le basculement du levier 28, et par là même la fermeture des interrupteurs 7a-7d pour court-circuiter les bobinages des capteurs.

Lorsque l'opérateur retire le module avec le levier que ce module porte, ce levier est nécessairement désolidarisé des coulisseaux 21 et 22, qui ne peuvent de fait pas être déplacés. Ainsi, une fois que le module a été retiré de l'embase, les interrupteurs sont nécessairement fermés pour court-circuiter les bobinages, et l'arbre 12 est immobilisé dans l'embase pour rendre l'ouverture des interrupteurs impossible sans replacer le module dans l'embase. Avantageusement, l'arbre et les coulisseaux sont montés dans l'embase pour être inaccessibles à l'opérateur lorsqu'elle est ouverte, c'est-à-dire lorsque le module a été retiré.

Lorsque le module doit être remis en place, l'opérateur s'assure d'abord que la poignée 9 est en position haute, et il emboîte alors le module 2 dans l'embase 3. Lorsque le module 2 est emboîté dans l'embase 3, l'opérateur peut abaisser la poignée 9, pour ouvrir les interrupteurs de court-circuitage 7a-7d afin de rendre le module opérationnel.

Comme on l'aura compris, lorsque le levier est dans sa position basse, il verrouille mécaniquement le module 2 dans l'embase 3, par exemple au moyen d'ergots du levier s'engageant dans des gorges de verrouillage correspondants formées dans l'embase. De manière analogue, lorsque le levier est remonté, il déverrouille mécaniquement le module de l'embase pour permettre son retrait, par exemple par la sortie d'ergots du levier qui quittent des gorges formées dans l'embase.

Plus particulièrement, lorsque l'opérateur abaisse le levier 28 de sa seconde position, haute, à sa première position, basse, le levier provoque, sensiblement à mi-course, l'ouverture des interrupteurs 7a-7d, et c'est seulement lorsque ce levier atteint sa première position, basse, qu'il active les moyens de mesure intégrés au module.

Cette séquence vise à éviter que des mesures soient faites lors de l'ouverture des interrupteurs 7a-7d, qui correspond à un régime électrique transitoire donnant par là même lieu à des mesures erronées, susceptibles par exemple de provoquer inutilement une coupure du réseau.

Complémentairement, et pour réduire encore ce risque, le module comporte des moyens pour assurer qu'un temps d'arrêt, ou temporisation, s'écoule nécessairement durant l'abaissement de ce levier depuis sa position haute jusqu'à sa position basse.

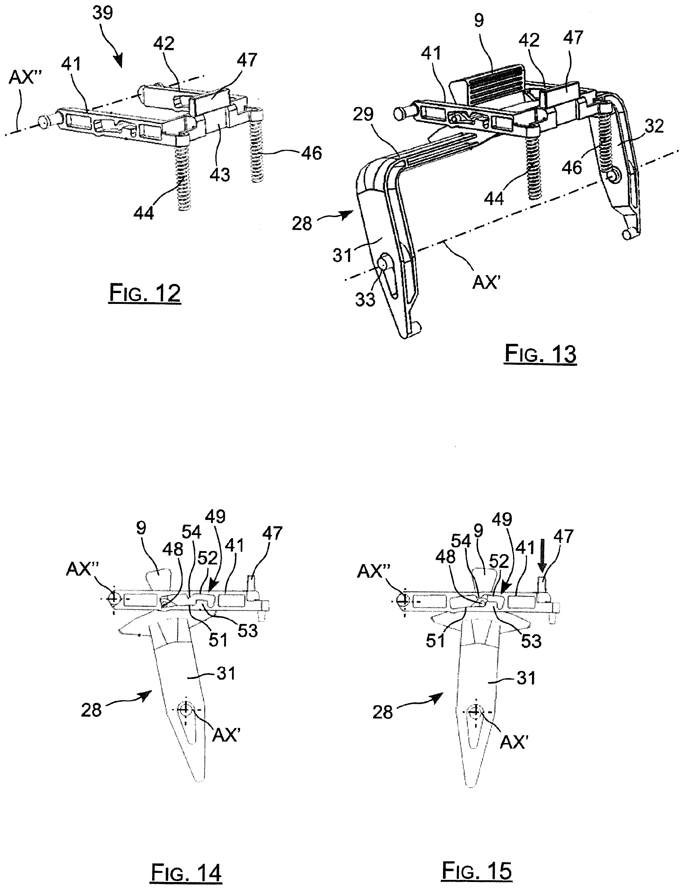

A cet effet, la poignée 9 est entourée par une armature 39 représentée seule sur la figure 12, qui comporte deux bras latéraux 41, 42 réunis par un bras transversal 43, cette armature 39 ayant ainsi une forme générale correspondant à celle de la lettre U.

Cette armature est portée par le module 2 en étant articulée au niveau des extrémité libres des bras 41 et 42 sur le châssis du module 2, de manière à pouvoir tourner autour d'un axe transversal AX" qui est orienté parallèlement à la portion centrale 29 du levier 28, c'est-à-dire parallèlement aux axes AX et AX'. Complémentairement, le bras transversal 43 de l'armature 39 est en appui au niveau de ses extrémités sur deux ressorts 44, 46 parallèles l'un à l'autre et d'orientation normale au plan que définissent les bras 41, 42 et 43 de l'armature.

Cette armature 39 est montée sous la paroi délimitant la façade avant du module 2, et elle comporte encore un bouton central 47, porté par le bras central 43 et dépassant de la paroi avant. Ainsi, lorsque l'armature 39 est en place dans le module 2, une pression sur son bouton central 47 a pour effet d'enfoncer cette armature 39 dans le module 2, à l'encontre des ressorts de rappel 44 et 46 qui tendent continuellement à la plaquer contre la face interne de la paroi avant du module.

Lorsque l'ensemble est monté, la poignée 9 est située entre les bras 41 et 42 de l'armature 39. Complémentairement, la poignée 9 comporte un ergot ou plot latéral 48 qui est engagé dans une gorge 49 formée dans le bras 41, de façon à pouvoir coulisser longitudinalement dans cette gorge. La gorge 49 est délimitée par un bord interne 51 qui est le plus proche de l'axe AX, et par un bord externe 52.

De la même manière la poignée 9 comporte un autre ergot latéral opposé à l'ergot 48, non visible sur les figures, qui coulisse ou glisse dans une gorge correspondante formée dans l'autre bras de l'armature 39, à savoir le bras 42.

Ainsi, lorsque la poignée 9 est déplacée de sa position haute à sa position basse, les plots latéraux de cette poignée sont assujettis à parcourir les gorges correspondantes formées dans les bras 41 et 42.

Comme visible sur la figure 14, la première moitié de la gorge 41 a une forme sensiblement rectiligne ou en arc centré sur l'axe AX, de sorte qu'elle ne constitue pas d'obstacle au déplacement du plot 48 pendant la première moitié de sa course correspondant à l'abaissement de la poignée 9.

Compte tenu des ressorts de rappel de l'armature, le plot 48 est en appui contre le bord interne 51 de la gorge 49. Lorsque le plot 48 atteint la moitié de la longueur de la gorge 49, le bord inférieur 51 de cette gorge comporte un ergot 53 formant obstacle au déplacement du plot 48, ce qui bloque la poignée 9 à mi-course lors de son abaissement, comme illustré sur la figure 15.

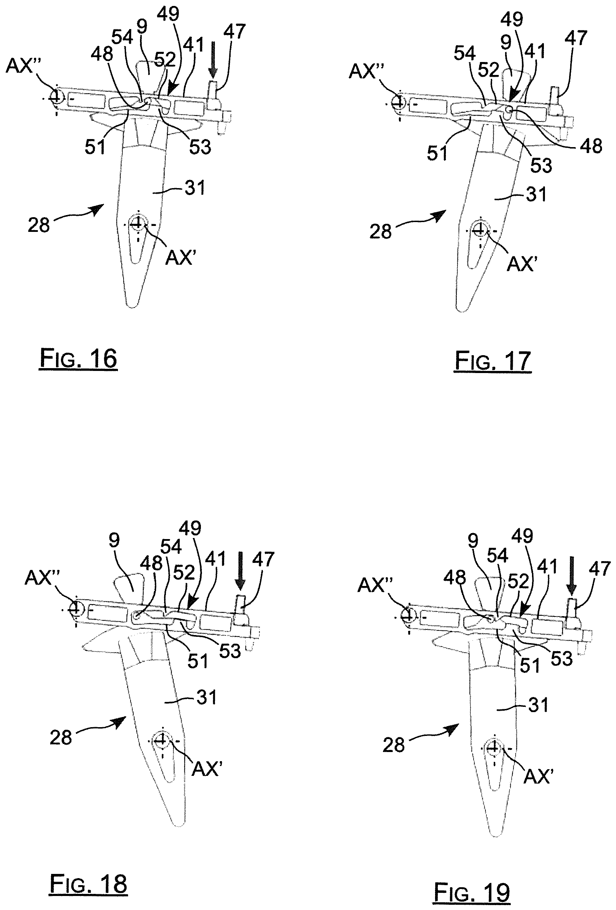

L'opérateur doit alors appuyer sur le bouton 47 porté par l'armature 39 pour enfoncer cette armature dans le module 2, comme illustré sur la figure 17. Ceci éloigne le bord 51 de l'ergot ou plot 48 pour libérer le passage et permettre à la poignée 9 de parcourir la deuxième moitié de sa course dans son mouvement d'abaissement afin de permettre son abaissement complet, comme sur la figure 17.

Ainsi, durant le mouvement d'abaissement, de la poignée 9, son plot latéral est intercepté par l'ergot 53 de la gorge, ce qui oblige l'opérateur à arrêter le mouvement d'abaissement de la poignée, le temps qu'il pousse le bouton 47 pour pouvoir mécaniquement abaisser complètement la poignée.

Autrement dit, le système de plots et de gorges formées dans les bras de l'armature 39 assure que l'abaissement de la poignée 9 ne peut pas être fait brutalement, mais au contraire avec un temps d'arrêt durant le mouvement en question.

Complémentairement, le bord externe 52 qui délimite la gorge 49 est lui aussi pourvu d'un autre ergot, repéré par 54 qui est situé en amont de l'ergot 53 par rapport au sens de la course d'abaissement de la poignée 9.

Ainsi, dans le cas où l'opérateur tenterait de pousser le bouton 47 avant d'abaisser la poignée 9, comme c'est le cas sur la figure 18, le plot 48 glisse alors le long du bord externe 52, et non pas le long du bord interne 51. Dans ces conditions, lorsque ce plot 48 arrive légèrement en amont de la mi-course le long de la gorge 46, il est intercepté par l'ergot 54, ce qui immobilise alors la poignée 9 à mi-course, comme illustré sur la figure 9.

Pour poursuivre la course, l'opérateur doit alors d'abord relâcher le bouton 47 et abaisser légèrement la poignée jusqu'à ce qu'elle vienne en appui sur le plot 53. Ceci correspond alors à la situation de la figure 16, dans laquelle il reste à enfoncer à n nouveau le bouton 47 pour pouvoir abaisser complètement la poignée 9.

## Revendications

1. Système (1) comprenant une embase (3) et un module débrochable (2) s'emboîtant dans cette embase (3), l'embase (3) étant destinée à être électriquement reliée à au moins un capteur d'intensité (6a-6d) équipant une ligne électrique (4) de type moyenne ou haute tension pour mesurer une intensité de courant transporté par cette ligne (4), chaque capteur (6a-6d) comprenant un bobinage, le module (2) comprenant pour chaque capteur (6a-6d) un transformateur de mesure (8a-8d) électriquement connecté via l'embase (3) au bobinage du capteur (6a-6d) correspondant, pour mesurer l'intensité du courant circulant dans la ligne (4), l'embase (3) comportant pour chaque capteur (6a-6d) un interrupteur (7a-7d) pour court-circuiter chaque bobinage de capteur (6a-6d) en cas de retrait du module (2), l'embase (3) comportant un mécanisme (13) d'actionnement des interrupteurs (7a-7d) pour les ouvrir ou les fermer, un levier de manoeuvre (28) équipant le module (2) en étant apte à verrouiller le module (2) dans l'embase (3), ce levier de manoeuvre (28) s'accouplant avec le mécanisme (13) d'actionnement des interrupteurs (7a-7d) lorsque le module (2) est emboîté dans l'embase (3), ce levier de manoeuvre (28) étant mobile entre une première position de verrouillage mécanique du module (2) dans l'embase (3) et d'ouverture de chaque interrupteur (7a-7d), et une deuxième position de fermeture des interrupteurs (7a-7d) et de déverrouillage du module (2) de l'embase (3).

2. Système selon la revendication 1, dans lequel :
- l'embase (3) comporte un arbre rotatif (12) d'actionnement de chaque interrupteur (7a-7d) qui est mobile entre une position d'ouverture et une position de fermeture de chaque interrupteur (7a-7d), et au moins un coulisseau (21, 22) d'entraînement de l'arbre (12) lié en mouvement à cet arbre (12) par une liaison de type pignon-crémaillère (23, 24) ;
- le levier de manoeuvre (28) du module (2) est lié en mouvement à chaque coulisseau (21, 22) de l'embase (3) lorsque ce module (2) est emboîté dans l'embase (3), pour placer l'arbre (12) en position d'ouverture lorsque le levier (28) occupe sa première position, et pour placer cet arbre (12) en position de fermeture lorsque le levier (28) occupe sa deuxième position.

3. Système selon la revendication 2, dans lequel le levier de manoeuvre (28) est monté basculant sur le module (2) qui le porte, dans lequel chaque coulisseau (21, 22) comporte une encoche (26, 27) d'accouplement recevant une extrémité correspondante (34, 37) du levier (28) lorsque le module (2) est emboîté dans l'embase (3), pour qu'un déplacement du levier provoque un déplacement correspondant des coulisseaux (21, 22) et de l'arbre rotatif (12).

4. Système selon l'une des revendications précédentes, comportant des moyens pour déclencher l'ouverture des interrupteurs (7a-7d) lorsque le levier (28) occupe une position intermédiaire entre sa première position et sa seconde position, et des moyens pour activer des mesure du courant circulant dans la ligne (4) lorsque le levier (28) a atteint sa première position.

5. Système selon la revendication 4, comportant des moyens pour temporiser le déplacement du levier (28) depuis sa deuxième position jusqu'à sa première position.

6. Système selon la revendication 5, dans lequel les moyens pour temporiser le déplacement du levier (28) comprennent un pion (48) rigidement solidaire du levier (28) et coulissant dans une gorge (49) en étant en appui sur un bord (51) de cette gorge (49), cette gorge (49) étant portée par une armature mobile (39) rappelée par des ressorts (44, 46) pour maintenir son bord (51) en appui sur le pion (48), le bord (51) comprenant entre ses extrémités un ergot (53) pour bloquer le pion (48) dans sa course, l'armature (39) comprenant un bouton poussoir (47) pouvant être enfoncé par un opérateur pour enfoncer l'armature mobile à l'encontre des ressorts (44, 46) de manière à effacer l'ergot (53) pour permettre au pion (48) de continuer sa course le long du bord (51).

7. Système selon l'une des revendications précédentes, dans lequel l'arbre (12) et les coulisseaux (21, 22) sont sensiblement inaccessibles à un opérateur lorsque le module (2) est retiré, pour interdire une manoeuvre des interrupteurs en l'absence du module (2).

## Patentansprüche

1. System (1), umfassend einen Sockel (3) und ein abnehmbares Modul (2), das in diesen Sockel (3) eingreift, wobei der Sockel (3) dazu bestimmt ist, mit zumindest einem Stromstärkensensor (6a - 6d) elektrisch verbunden zu werden, mit welchem eine elektrische Mittel- bzw. Hochspannungsleitung (4) versehen ist, um eine Stromstärke zu messen, die über diese Leitung (4) geführt wird, wobei jeder Sensor (6a - 6d) eine Wicklung umfasst, das Modul (2) für jeden Sensor (6a - 6d) einen Messwandler (8a - 8d) umfasst, der über den Sockel (3) mit der Wicklung des entsprechenden Sensors (6a - 6d) elektrisch verbunden ist, um die Stromstärke des in der Leitung (4) fließenden Stroms zu messen, wobei der Sockel (3) für jeden Sensor (6a - 6d) einen Schalter (7a - 7d) enthält, um jede Sensorwicklung (6a - 6d) bei Entfernen des Moduls (2) kurzzuschließen, wobei der Sockel (3) einen Betätigungsmechanismus (13) zum Betätigen der Schalter (7a - 7d) umfasst, um diese zu öffnen bzw. zu schließen, wobei ein Bedienhebel (28), mit dem das Modul (2) versehen ist, dazu ausgelegt ist, das Modul (2) in dem Sockel (3) zu verriegeln, wobei dieser Bedienhebel (28) sich an den Betätigungsmechanismus (13) zum Betätigen der Schalter (7a - 7d) dann ankoppelt, wenn das Modul (2) in den Sockel (3) eingreift, wobei dieser Bedienhebel (28) zwischen einer ersten Stellung zum mechanischen Verriegeln des Moduls (2) in dem Sockel (3) und zum Öffnen eines jeden Schalters (7a - 7d) und einer zweiten Stellung zum Schließen der Schalter (7a - 7d) und zum Entriegeln des Moduls (2) von dem Sockel (3) beweglich ist.

2. System nach Anspruch 1, wobei
- der Sockel (3) eine drehbare Welle (12) zum Betätigen eines jeden Schalters (7a - 7d) umfasst, die zwischen einer Öffnungsstellung und einer Schließstellung eines jeden Schalters (7a - 7d) beweglich ist, sowie zumindest einen Schieber (21, 22) zum Antreiben der Welle (12), der über eine Verbindung vom Typ Ritzel-Zahnstange (23, 24) mit dieser Welle (12) bewegbar verbunden ist;
- der Bedienhebel (28) des Moduls (2) mit jedem Schieber (21, 22) des Sockels (3) dann bewegbar verbunden ist, wenn dieses Modul (2) in den Sockel (3) eingreift, um die Welle (12) in die Öffnungsstellung zu verlagern, wenn der Hebel (28) seine erste Stellung einnimmt, und um diese Welle (12) in die Schließstellung zu verlagern, wenn der Hebel (28) seine zweite Stellung einnimmt.

3. System nach Anspruch 2, wobei der Bedienhebel (28) an dem diesen abstützenden Modul (2) verschwenkbar gelagert ist, wobei jeder Schieber (21, 22) eine Koppeleinkerbung (26, 27) umfasst, die ein entsprechendes Ende (34, 37) des Hebels (28) dann aufnimmt, wenn das Modul (2) in den Sockel (3) eingreift, damit eine Verlagerung des Hebels eine entsprechende Verlagerung der Schieber (21, 22) und der drehbaren Welle (12) hervorruft.

4. System nach einem der vorangehenden Ansprüche, umfassend Einrichtungen, um das Öffnen der Schalter (7a - 7d) dann auszulösen, wenn der Hebel (28) eine Zwischenstellung zwischen seiner ersten Stellung und seiner zweiten Stellung einnimmt, sowie Einrichtungen, um das Messen von in der Leitung (4) fließendem Strom dann zu aktivieren, wenn der Hebel (28) seine erste Stellung erreicht hat.

5. System nach Anspruch 4, umfassend Einrichtungen zum Verzögern der Verlagerung des Hebels (28) aus seiner zweiten Stellung in seine erste Stellung.

6. System nach Anspruch 5, wobei die Einrichtungen zum Verzögern der Verlagerung des Hebels (28) einen Zapfen (48) aufweisen, der mit dem Hebel (28) starr verbunden ist und in einer Nut (49) gleitet, indem er in Anlage an einen Rand (51) dieser Nut (49) ist, wobei diese Nut (49) von einer beweglichen Armatur (29) getragen ist, die über Federn (44, 46) zurückgestellt wird, um ihren Rand (51) in Anlage an den Zapfen (48) zu halten, wobei der Rand (51) zwischen seinen Enden eine Nase (53) aufweist, um den Zapfen (48) auf seinem Verlagerungsweg zu blockieren (48), wobei die Armatur (39) einen Druckknopf (47) aufweist, der von einer Bedienperson niedergedrückt werden kann, um die bewegliche Armatur entgegen der Federn (44, 46) so niederzudrücken, dass die Nase (53) nachgibt, um dem Zapfen (48) zu gestatten, seinen Verlagerungsweg entlang des Randes (51) fortzusetzen.

7. System nach einem der vorangehenden Ansprüche, wobei die Welle (12) und die Schieber (21, 22) für eine Bedienperson im Wesentlichen unzugänglich sind, wenn das Modul (2) entfernt ist, um eine Handhabung der Schalter bei fehlendem Modul (2) zu unterbinden.

## Claims

1. A system (1) comprising a base (3) and a removable module (2) nesting in this base (3), the base (3) being intended to be electrically connected to at least one intensity sensor (6a-6d) equipping an electrical line (4) of the medium- or high-voltage type to measure a current intensity transported by this line (4), each sensor (6a-6d) comprising a winding, the module (2) comprising, for each sensor (6a-6d), a measuring transformer (8a-8d) electrically connected via the base (3) to the winding of the corresponding sensor (6a-6d), to measure the intensity of the current circulating in the line (4), the base (3) including, for each sensor (6a-6d), a switch (7a-7d) to short-circuit each sensor winding (6a-6d) in case of removal of the module (2), the base (3) including a mechanism (13) for actuating the switches (7a-7d) to open or close them, a maneuvering lever (28) equipping the module (2) while being able to lock the module (2) in the base (3), this maneuvering lever (28) coupling with the mechanism (13) for actuating the switches (7a-7d) when the module (2) is nested in the base (3), this maneuvering lever (28) being movable between a first position for mechanical locking of the module (2) in the base (3) and opening of each switch (7a-7d), and a second position for closing the switches (7a-7d) and unlocking the module (2) from the base (3).

2. The system according to claim 1, wherein:
- the base (3) includes a rotary shaft (12) for actuating each switch (7a-7d) that is movable between an open position and a closed position of each switch (7a-7d), and at least one slide (21, 22) driving the shaft (12) connected in movement to this shaft (12) by a connection of the pinion-rack type (23, 24);
- the maneuvering lever (28) of the module (2) is connected in movement to each slide (21, 22) of the base (3) when this module (2) is nested in the base (3), to place the shaft (12) in the open position when the lever (28) occupies its first position, and to place this shaft (12) in the closed position when the lever (28) is in its second position.

3. The system according to claim 2, wherein the maneuvering lever (28) is mounted tilting on the module (2) that bears it, wherein each slide (21, 22) includes a coupling notch (26, 27) receiving a corresponding end (34, 37) of the lever (28) when the module (2) is nested in the base (3), so that a movement of the lever causes a corresponding movement of the slides (21, 22) and the rotary shaft (12).

4. The system according to one of the preceding claims, including means for triggering the opening of the switches (7a-7d) when the lever (28) occupies an intermediate position between its first position and its second position, and means for activating measurements of the current circulating in the line (4) when the lever (28) has reached its first position.

5. The system according to claim 4, including means for instituting a time delay of the movement of the lever (28) from its second position to its first position.

6. The system according to claim 5, wherein the means for instituting a time delay of the movement of the lever (28) comprise a pin (48) rigidly secured to the lever (28) and sliding in a groove (49) while bearing on an edge (51) of this groove (49), this groove (49) being supported by a moving framework (39) recalled by springs (44, 46) to keep its edge (51) bearing on the pin (48), the edge (51) comprising, between its ends, a lug (53) to block the travel of the pin (48), the framework (39) comprising a pushbutton (47) able to be pushed in by an operator to push the movable framework in against the springs (44, 46) so as to retract the lug (53) to allow the pin (48) to continue to travel along the edge (51).

7. The system according to one of the preceding claims, wherein the shaft (12) and the slides (21, 22) are substantially inaccessible to an operator when the module (2) is removed, to prohibit maneuvering of the switches when the module (2) is not present.
